# EUROPEAN PATENT APPLICATION

(11) **EP 4 765 473 A1**
(43) Date of publication of application: **24.06.2026**
(21) Application number: 24854277.1
(22) Date of filing: 12.06.2024
(51) Int. Cl.: H01P 1/203, H01P 7/08

(54) **FILTER STRUCTURE**

(30) Priority: 16.08.2023 KR 20230107244
(71) Applicant: KMW Inc., Hwaseong-si, Gyeonggi-do 18462 (KR)
(72) Inventor: PARK, Nam Shin, Hwaseong-si Gyeonggi-do 18447 (KR)
(74) Representative: impuls legal PartG mbB
(86) International application number: PCT/KR2024/008029
(87) International publication number: WO 2025/037724

(57) **Abstract**

A filter structure is disclosed.

According to an embodiment of the present disclosure, provided is a filter structure comprising: a housing: a ground member disposed inside the housing and having one side coming in contact with the housing; a wall member extending from the inner surface of the housing to be in contact with the ground member; a plurality of resonators disposed inside the housing and disposed on straight lines extending in the radial direction from the ground member; an input port connected to one of the plurality of resonators; and an output port connected to another one of the plurality of resonators, wherein the plurality of resonators are arranged apart from each other, and one side of at least one of the plurality of resonators is connected to the ground member.

## Description

### Technical Field

The present disclosure relates to a filter structure.

### Background Art

The content described in this section is provided merely to offer background information related to the present disclosure and does not constitute prior art.

A filter is a device that blocks undesired signals and allows only desired signals to pass there through by using frequency responses. Filters include a high-pass filter (HPF), a band-pass filter (BPF), and a low-pass filter (LPF).

A high-pass filter (HPF) is a filter that allows high-frequency signals to pass there through and blocks low-frequency signals. A band-pass filter (BPF) is a filter that allows signals within a predetermined frequency bandwidth to pass there through and blocks signals outside the bandwidth. A low-pass filter (LPF) is a filter that allows low-frequency signals to pass there through and blocks high-frequency signals.

Depending on frequency signals that a filter allows to pass and frequency signals that the filter blocks, a frequency response graph has a varying waveform. A passband refers to a range of frequencies that the filter allows to pass there through. A stopband refers to a range of frequencies that the filter blocks. Frequency responses are important factors that determine responses of the filter.

It is not easy to obtain desired frequency responses. In order to obtain desired frequency responses, a structure of the filter may become complicated and manufacturing processes may increase, thereby increasing manufacturing cost. For example, a notch may be generated to obtain desired frequency responses. The notch refers to a section in which an amplitude of the frequency response graph is sharply reduced. When the notch is formed, attenuation performance is improved; however, in order to form the notch, installation of an additional structure may be required.

### Detailed Description of the Invention

### Technical Problem

Accordingly, the present disclosure has been made to solve the above-described problems, and a primary object thereof is to provide a filter structure capable of generating a notch on a frequency response graph without installing an additional structure.

In addition, a primary object of the present disclosure is to provide a filter structure in which cross-coupling occurs between non-adjacent resonators.

In addition, a primary object of the present disclosure is to provide a filter structure in which resonators are arranged in an interdigital form so as to easily form a notch at a desired frequency.

### Technical Solution

According to an embodiment of the present disclosure for achieving the above-described objects, provided is a filter structure comprising a housing; a ground member disposed inside the housing and having one side in contact with the housing; a wall member extending from an inner surface of the housing and being in contact with the ground member; a plurality of resonators disposed inside the housing and disposed along straight lines extending in a radial direction from the ground member; an input port connected to one of the plurality of resonators; and an output port connected to another one of the plurality of resonators, wherein the plurality of resonators are spaced apart from each other, and at least one of the plurality of resonators has one side connected to the ground member.

### Effects of the Invention

As described above, according to the present embodiment, the filter structure has an effect of generating a notch on a frequency response graph without installing an additional structure.

In addition, the present disclosure has an effect in which cross-coupling may occur between non-adjacent resonators.

In addition, the present disclosure has an effect of easily forming a notch at a desired frequency by arranging the resonators in an interdigital form.

### Brief Description of the Drawings

FIG. 1 is an exploded perspective view of a filter structure according to a first embodiment of the present disclosure.
FIG. 2 is a plan view of the filter structure according to the first embodiment of the present disclosure.
FIG. 3 is a cross-sectional view of the filter structure according to the first embodiment of the present disclosure.
FIG. 4 is a frequency response graph according to the first embodiment of the present disclosure.
FIG. 5 is an exploded perspective view of a filter structure according to a second embodiment of the present disclosure.
FIG. 6 is a plan view of the filter structure according to the second embodiment of the present disclosure.
FIG. 7 is a frequency response graph according to the second embodiment of the present disclosure.
FIG. 8 is an exploded perspective view of a filter structure according to a third embodiment of the present disclosure.
FIG. 9 is a plan view of the filter structure according to the third embodiment of the present disclosure.
FIG. 10 is a frequency response graph according to the third embodiment of the present disclosure.
FIG. 11 is an exploded perspective view of a filter structure according to a fourth embodiment of the present disclosure.
FIG. 12 is a plan view of the filter structure according to the fourth embodiment of the present disclosure.
FIG. 13 is a frequency response graph according to the fourth embodiment of the present disclosure.
FIG. 14 is an exploded perspective view of a filter structure according to a fifth embodiment of the present disclosure.
FIG. 15 is a plan view of the filter structure according to the fifth embodiment of the present disclosure.
FIG. 16 is a frequency response graph according to the fifth embodiment of the present disclosure.

### Detailed Description of the Invention

Hereinafter, some embodiments of the present disclosure will be described in detail with reference to the accompanying exemplary drawings. In adding reference numerals to elements of the drawings, the same reference numerals are used to denote the same elements even though they are illustrated in different drawings, as much as possible. In addition, in describing the present disclosure, detailed descriptions of related known configurations or functions will be omitted when it is determined that such descriptions may obscure the gist of the present disclosure.

In describing elements of the present disclosure, terms such as first, second, A, B, (a), and (b) may be used. Such terms are used only to distinguish one element from another, and do not limit the nature, order, or sequence of the corresponding elements.

When it is described that one element is "connected," "coupled," or "joined" to another element, it should be understood that the one element may be directly coupled or joined to the other element, but another element may also be "connected," "coupled," or "joined" between the respective components.

Throughout the specification, when a part is described as "comprising" or "including" an element, this does not exclude other elements unless explicitly stated otherwise, and means that other elements may be further included.

In the specification, terms such as "unit" and "module" refer to a unit that processes at least one function or operation, and may be implemented as hardware, software, or a combination of hardware and software.

Unless stated otherwise, the description of an embodiment may be applied to other embodiments.

The description of the present disclosure disclosed below with reference to the accompanying drawings is intended to describe exemplary embodiments of the present disclosure, and is not intended to represent the only embodiments in which the present disclosure may be practiced.

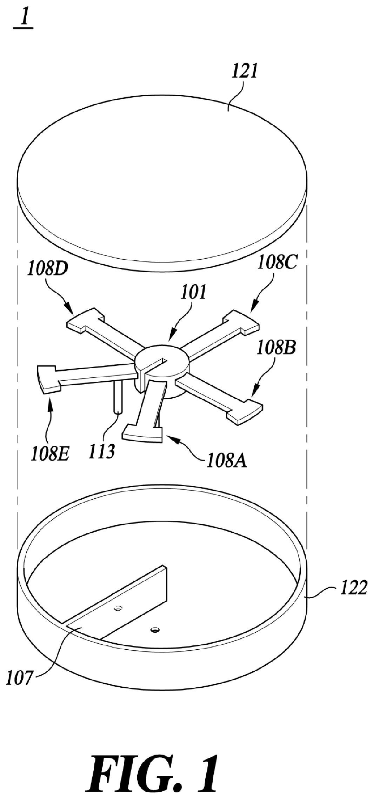

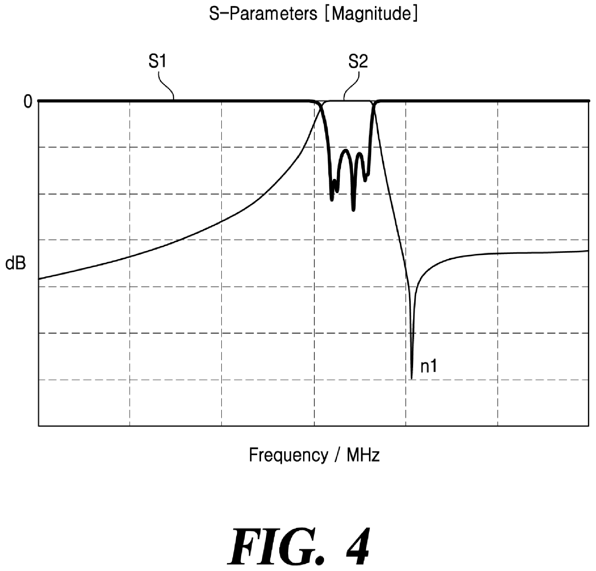

FIGS. 1 to 4 are each view showing a filter structure and a frequency response graph according to a first embodiment of the present disclosure.

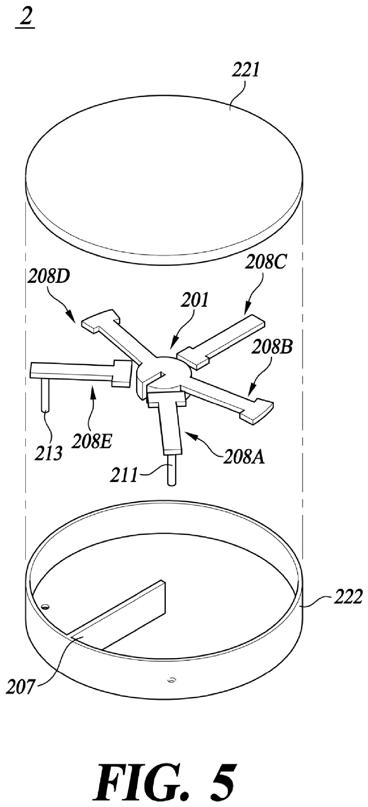

FIGS. 5 to 7 are each view showing a filter structure and a frequency response graph according to a second embodiment of the present disclosure.

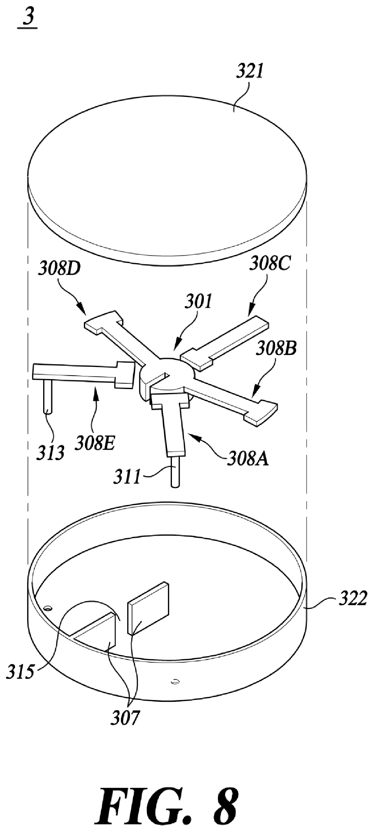

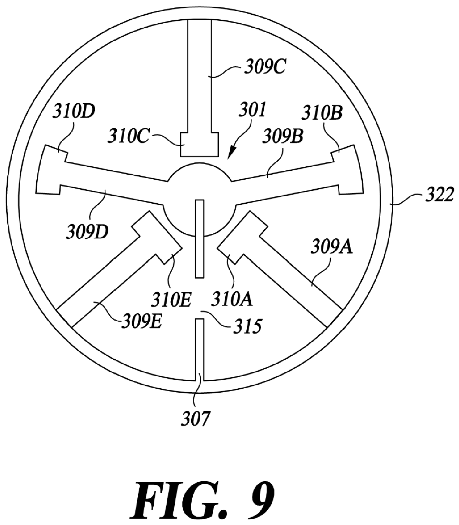

FIGS. 8 to 10 are each view showing a filter structure and a frequency response graph according to a third embodiment of the present disclosure.

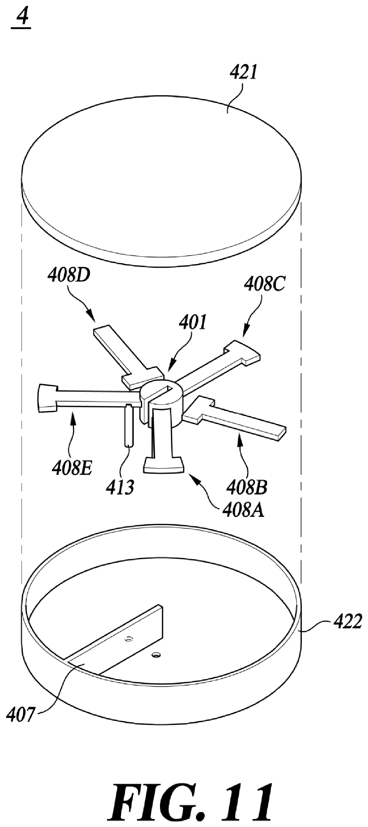

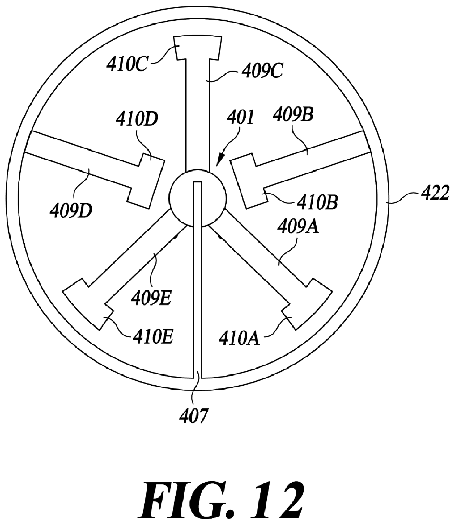

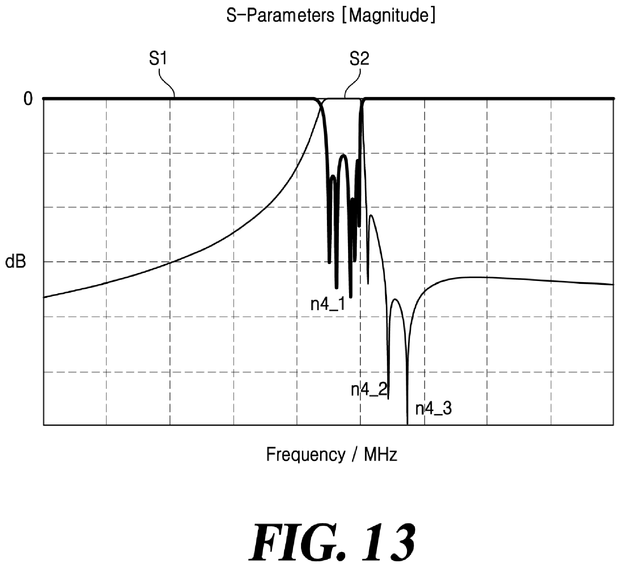

FIGS. 11 to 13 are each view showing a filter structure and a frequency response graph according to a fourth embodiment of the present disclosure.

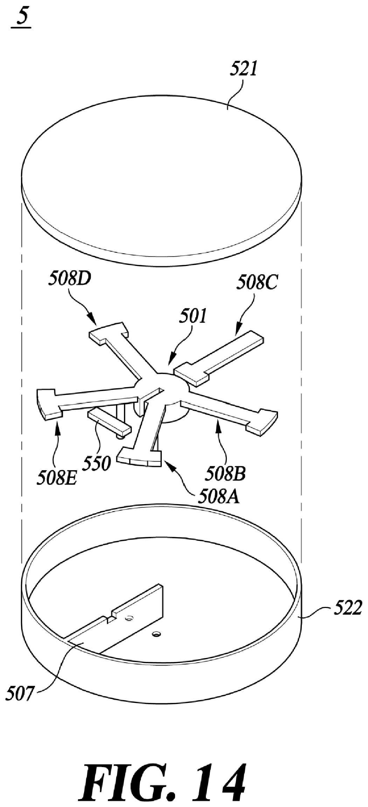

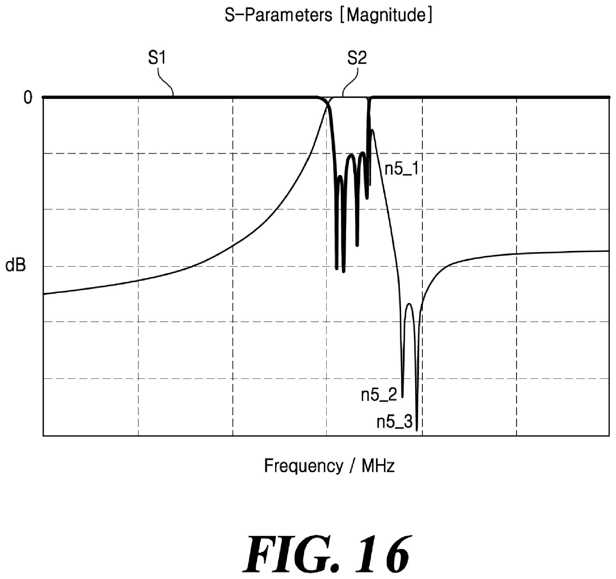

FIGS. 14 to 16 are each view showing a filter structure and a frequency response graph according to a fifth embodiment of the present disclosure.

Hereinafter, features of the filter structure (1 to 5) according to the present disclosure will be described with reference to the first embodiment (FIGS. 1 to 4) and/or the second embodiment (FIGS. 5 to 7). For portions without contradiction, descriptions will be made with reference to the reference numerals of the drawings of the first embodiment and/or the second embodiment. For example, with respect to a plurality of resonators (108, 208, 308, 408, 508) according to various embodiments, for the sake of brevity of the specification, the resonators will be briefly described using reference numeral 108 of the drawings of the first embodiment and/or reference numeral 208 of the drawings of the second embodiment. With respect to features not included in the first embodiment and/or the second embodiment, descriptions will be made with reference to the third to fifth embodiments or will be described later.

Referring to FIGS. 1 to 16, the filter structure (1 to 5) according to the present disclosure includes all or some of a housing (120), a ground member (101), a wall member (107), a plurality of resonators (108, 208), an input port (111), an output port (113), and a penetration member (550).

The housing (120) accommodates components therein. The housing (120) may include an upper case (121) and a lower case (122). The size and shape of the housing (120) are not limited by the disclosure of the drawings. An upper surface of the upper case (121) of the housing (120) may have a circular shape. A lower surface of the lower case (122) of the housing (120) may have a circular shape. A longitudinal cross section of the housing (120) may have a circular shape. The longitudinal cross section of the housing (120) may have a polygonal shape. Frequency responses of the filter structure (1 to 5) may vary depending on the shape of the housing (120) and a size of an accommodating space inside the housing (120). The size and shape of the housing (120) may be adjusted to meet required specifications.

Resonators (108, 208) may be in contact with an inner surface of the housing (120). In this case, the resonators (108, 208) are grounded to the housing (120). When m is a natural number equal to or greater than 3, a case in which m resonators (108, 208) are in contact with the housing (120) is assumed. To facilitate contact of the m resonators (108, 208) with the housing (120), a cross section of the inner surface of the housing (120) that is perpendicular to a longitudinal direction thereof may have an m-sided polygonal shape. As described above, since the inner surface of the housing (120) on which the resonators (108, 208) are disposed is not a planar surface having zero curvature, cross coupling to be described later may occur when the resonators (108, 208) are disposed along the inner surface of the housing (120). Since a plurality of resonators (108, 208) disposed along the inner surface of the housing (120) are not parallel to each other, cross coupling may occur. That is, the filter structure (1 to 5) according to the present disclosure does not require installation of an additional structure on the plurality of resonators (108, 208) in order to generate cross coupling.

The ground member (101) is disposed inside the housing (120). The ground member (101) may be disposed at a center of the housing (120).

A longitudinal cross section of the ground member (101) may have a circular shape. The longitudinal cross section of the ground member (101) may have a polygonal shape. When m is a natural number equal to or greater than 3, a case in which m resonators (108, 208) are in contact with the ground member (101) is assumed. To facilitate contact of the m resonators (108, 208) with the ground member (101), a cross section of the ground member (101) that is perpendicular to a longitudinal direction thereof may have an m-sided polygonal shape. The size and shape of the ground member (101) are not limited by the disclosure of the drawings. As described above, since an outer surface of the ground member (101) on which the resonators (108, 208) are disposed is not a planar surface having zero curvature, cross coupling to be described later may occur when the resonators (108, 208) are disposed along the outer surface of the ground member (101). Since a plurality of resonators (108, 208) disposed along the outer surface of the ground member (101) are not parallel to each other, cross coupling may occur. That is, it is not necessary to install an additional structure on the plurality of resonators (108, 208) in order to generate cross coupling.

The ground member (101) may be in contact with the wall member (107). A portion of the wall member (107) may be inserted into the ground member (101).

According to an embodiment, the ground member (101) may be connected to at least one of the plurality of resonators (108, 208). A resonator (108, 208) connected to the ground member (101) may not be in contact with the housing (120).

According to an embodiment, the ground member (101) may be grounded by being in contact with one side of the housing (120). Another side of the ground member (101) may not be in contact with the housing (120). Specifically, a lower surface (103) of the ground member (101) is in contact with the lower case (122) of the housing (120), and an upper surface (102) of the ground member (101) is not in contact with the housing (120). In this case, an empty space is formed between the housing (120) and the upper surface (102) of the ground member (101), such that cross coupling may occur. Cross coupling refers to a phenomenon in which an electrical connection occurs between non-adjacent resonators (108, 208). For example, a case in which a first resonator (108A) and a third resonator (108C), which are not adjacent to each other, are electrically connected may occur. Various forms of notches (n) may be generated by cross coupling. Shapes of the notches that may be generated by cross coupling are not limited by the shapes disclosed in the drawings. A notch (n) refers to a portion in which a waveform of a frequency response graph sharply changes and decreases. The notch (n) may be utilized to obtain desired frequency responses, such as improvement of attenuation performance. For example, a notch (n) may be generated on a left side and/or a right side with respect to a passband illustrated in the frequency response graph.

In order to obtain frequency responses under desired conditions, shapes, sizes, positions, and numbers of the ground member (101), the housing (120), the plurality of resonators (108, 208), the wall member (107), the passage (315), and the penetration member (550) may be adjusted, and a notch may be generated.

The wall member (107) may be formed to extend from an inner surface of the housing (120). The wall member (107) may be in contact with the ground member (101). The wall member (107) may be disposed between a resonator connected to the input port (111) and a resonator connected to the output port (113). For example, the wall member (107) may be disposed between a first resonator (108A) and a fifth resonator (108E). The wall member (107) may be disposed so as to be in contact with the upper case (121). The wall member (107) may be disposed so as to be in contact with the lower case (122).

The wall member (107) may block an electrical connection between the plurality of resonators (108, 208). For example, an electrical connection may be prevented from occurring by using a path (P1) penetrating the wall member (107). For example, an electrical connection between a first resonator (108A) and a fifth resonator (108E), which are disposed adjacent to each other, may be blocked.

By adjusting shapes, sizes, positions, and numbers of the wall member (107), frequency responses of the filter structure (1 to 5), a number of notches (n), and positions of the notches (n) may be adjusted. The shapes, sizes, positions, and numbers of the wall member (107) are not limited by the disclosure of the drawings.

The wall member (107) may comprise a passage (315) for generating an electrical connection between the plurality of resonators (108, 208). Although the wall member (107) functions to block an electrical connection, when the wall member comprises the passage (315), an electrical connection may occur between the plurality of resonators (108, 208). By adjusting a shape, a size, a position, and a number of the passage (315), frequency responses of the filter structure (1 to 5), a position of a notch (n), and a number of notches (n) may be adjusted. The shape, size, position, and number of the passage (315) are not limited by the disclosure of the drawings. For example, the passage (315) may be formed to be smaller than a shape illustrated in the drawings. For example, unlike the drawings, the passage (315) may have a circular shape.

The plurality of resonators (108, 208) are disposed inside the housing (120). In order to obtain a desired notch and/or desired frequency responses, a shape, a size, a position, and a number of the resonators (108, 208) may be adjusted. The plurality of resonators (108, 208) may be disposed spaced apart from each other. The plurality of resonators (108, 208) may be disposed along straight lines extending in a radial direction from the ground member (101).

The plurality of resonators (108, 208) may be disposed so as not to be parallel to each other. A shape of an outer surface of the ground member (101) may be formed such that the plurality of resonators (108, 208) are disposed not parallel to each other. A shape of an inner surface of the housing (120) may be formed such that the plurality of resonators (108, 208) are disposed not parallel to each other. When the plurality of resonators (108, 208) are disposed not parallel to each other, cross coupling may occur. By adjusting the cross coupling, desired frequency responses may be obtained.

According to an embodiment, at least one of the plurality of resonators (108, 208) may be connected to the ground member (101). The resonator (108) connected to the ground member (101) may not be in contact with an inner surface of the housing (120).

According to an embodiment, at least one of the plurality of resonators (108, 208) may not be connected to the ground member (101). The resonator (108, 208) not connected to the ground member (101) may be in contact with the inner surface of the housing (120).

At least one of the plurality of resonators (108, 208) may comprise a head portion (110). The head portion (110) may be formed at one side of a body (109) of each of the resonators (108, 208). By adjusting a shape, a size, a position, and a number of the head portion (110), a frequency response graph of the filter structure (1 to 5), a position of a notch (n), and a number of notches (n) may be varied.

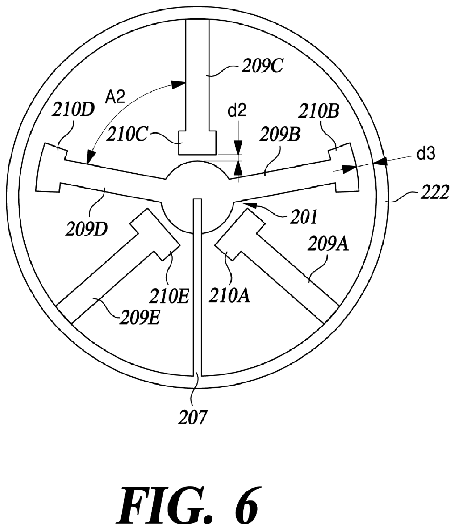

According to an embodiment, the resonator (108, 208) among the plurality of resonators (108, 208) that is connected to the ground member (101) may comprise the head portion (110) at one side adjacent to the inner surface of the housing (120). According to an embodiment, the resonator among the plurality of resonators (108, 208) that is not connected to the ground member (101) may comprise the head portion (110) at one side adjacent to the ground member (101). For example, among the resonators (208) of the second embodiment (FIGS. 5 and 6), a second resonator (208B) and a fourth resonator (208D), which are connected to the ground member (201), comprise head portions (210B, 210D) at one side adjacent to a lower case (222). For example, a first resonator (208A), a third resonator (208C), and a fifth resonator (208E), which are not connected to the ground member (201), comprise head portions (210A, 210C, 210E) at one side adjacent to the ground member (201).

Shapes, sizes, positions, and numbers of the plurality of resonators (108, 208) are not limited by the disclosure of the drawings. A size and/or a shape of each of the plurality of resonators (108, 208) may be independently formed.

Unlike conventional resonators that are disposed perpendicular to a plane, the plurality of resonators (108, 208) according to the present disclosure are disposed to be in contact with an outer surface of the ground member (101) or disposed to be in contact with an inner surface of the housing (120). That is, the plurality of resonators (108, 208) according to the present disclosure are disposed not parallel to each other. Since the plurality of resonators are disposed not parallel to each other, cross coupling may occur. In the case of conventional resonators (108), an additional structure must be installed to generate cross coupling; however, in the case of the plurality of resonators (108, 208) according to the present disclosure, cross coupling may be generated without an additional structure. That is, an effect of reducing cost may be achieved.

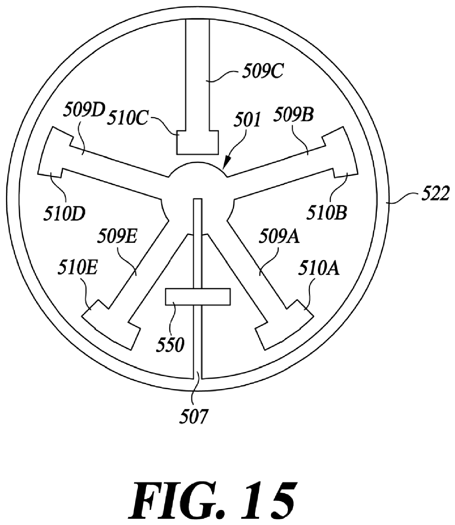

All or some of the plurality of resonators (108, 208) may be arranged in an interdigital form. The interdigital form refers to a form in which resonators (108, 208) connected to the ground member (101) and resonators (108, 208) not connected to the ground member (101) are alternately arranged. For example, in the second embodiment (FIGS. 5 and 6), a first resonator (208A) not connected to the ground member (201), a second resonator (208B) connected to the ground member (201), a third resonator (208C) not connected to the ground member (201), a fourth resonator (208D) connected to the ground member (201), and a fifth resonator (208E) not connected to the ground member (201) are alternately arranged. As in the fifth embodiment (FIGS. 14 and 15), only a portion of the plurality of resonators may be arranged in the interdigital form. For example, in the fifth embodiment, a second resonator (508B), a third resonator (508C), and a fourth resonator (508D) are arranged in the interdigital form. When the plurality of resonators is arranged in the interdigital form, a plurality of notches (n) may be easily formed. Desired frequency responses may be obtained by using the interdigital arrangement.

The input port (111) may be connected to one of the plurality of resonators (108, 208). The output port (113) may be connected to one of the plurality of resonators (108, 208).

According to an embodiment, the resonator (108, 208) connected to the input port (111) and the resonator (108, 208) connected to the output port (113) may be disposed adjacent to each other. According to an embodiment, the wall member (107) may be disposed between the resonator (108, 208) connected to the input port (111) and the resonator (108, 208) connected to the output port (113).

The penetration member (550) may penetrate the wall member (107, 507). The penetration member (550) may be fixed by the wall member (107, 507). One or more penetration members (550) penetrating the wall member (107, 507) may be provided. Although the wall member (107, 507) performs a function of blocking an electrical connection, an electrical connection may occur between the plurality of resonators (108, 208) by the penetration member (550).

Shapes, sizes, positions, and numbers of the penetration member (550) are not limited by the disclosure of the drawings. The penetration member (550) disclosed in FIG. 14 is disposed at a position adjacent to the upper case (521); however, the present disclosure is not limited thereto. The penetration member (550) may be disposed closer to the lower case (522). The penetration member (550) may be disposed on the same plane as the plurality of resonators (508). By adjusting shapes, sizes, positions, and numbers of the penetration member (550), frequency responses, a position of a notch (n), and a number of notches (n) may be adjusted.

A first embodiment will be described below. Descriptions will focus on matters not previously described. Descriptions overlapping with those described above will be omitted or briefly described.

Referring to FIGS. 1 to 4, according to a first embodiment of the present disclosure, all of the plurality of resonators (108) may be connected to the ground member (101). The filter structure (1) according to the first embodiment may comprise a first resonator (108A) to a fifth resonator (108E). The first resonator (108A) is connected to the input port (111), and the fifth resonator (108E) may be connected to the output port (113).

In the filter structure (1) according to the first embodiment, cross coupling may occur. For example, the first resonator (108A) may be electrically connected to non-adjacent resonators, such as the third resonator (108C), the fourth resonator (108D), and the fifth resonator (108E). A notch (n1) may be generated by the cross coupling. The notch (n1) may be generated on a right side with respect to a passband of a frequency response graph.

The first resonator (108A) to the fifth resonator (108E) are disposed so as not to be parallel to each other. This is because a shape of an outer surface of the ground member (101) is not a planar surface having zero curvature. Head portions (110) of the first resonator (108A) to the fifth resonator (108E) are disposed to face different directions from each other. Since the first resonator (108A) to the fifth resonator (108E) are not parallel to each other, cross coupling may occur.

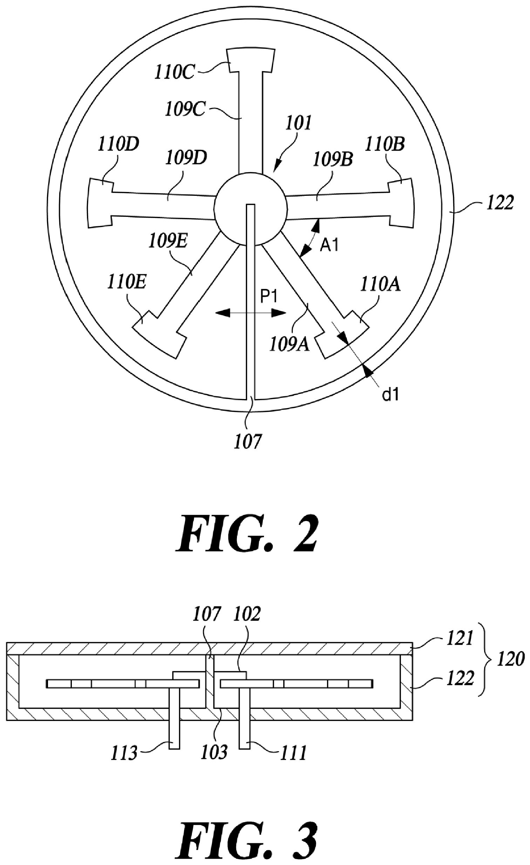

An upper surface (102) of the ground member (101) and the upper case (121) are not in contact with each other (FIG. 3). That is, an empty space is formed between the upper surface (102) of the ground member (101) and the housing (120). Cross coupling may occur due to the empty space.

Frequency responses may vary depending on an angle between adjacent resonators (108). For example, when an angle (A1, FIG. 2) between a first resonator (108A) and a second resonator (108B), which are adjacent to each other, is varied, a waveform of a frequency response graph, a position of a notch (n1), a number of notches (n1), and a magnitude of amplitude reduction may be varied. Angles between the plurality of resonators (108) may be independently formed. For example, the angle (A1) between the first resonator (108A) and the second resonator (108B) and an angle between the second resonator (108B) and a third resonator (108C) may be the same as or different from each other.

Frequency responses may vary depending on a distance between a head portion (110) and an inner surface of the housing (120). For example, when a distance (d1) between a first head portion (110A) and the inner surface of the housing (120) in FIG. 2 is varied, a waveform of a frequency response graph, a position of a notch (n1), a number of notches (n1), and a magnitude of amplitude reduction may be varied. Distances between the head portion (110) and the inner surface of the housing (120) may be independently formed. For example, the distance (d1) between the first head portion (110A) and the inner surface of the housing (120) and a distance between a second head portion (110B) and the inner surface of the housing (120) may be the same as or different from each other.

A second embodiment will be described below. Descriptions will focus on matters not previously described. Descriptions overlapping with those described above will be omitted or briefly described.

Referring to FIGS. 5 to 7, a filter structure (2) according to a second embodiment of the present disclosure may comprise a first resonator (208A) to a fifth resonator (208E). The first resonator (208A) to the fifth resonator (208E) may be sequentially arranged along a counterclockwise direction about the ground member (201). The first resonator (208A) is connected to the input port (211), and the fifth resonator (208E) may be connected to the output port (213).

According to the second embodiment of the present disclosure, the first resonator (208A), the third resonator (208C), and the fifth resonator (208E) are not connected to the ground member (201), and the second resonator (208B) and the fourth resonator (208D) may be connected to the ground member (201). According to the second embodiment, a notch (n2) may be generated on a right side with respect to a passband illustrated in a frequency response graph.

According to the second embodiment, an arrangement of the plurality of resonators (208) may be in an interdigital form. Specifically, a first resonator (208A) not connected to the ground member (201), a second resonator (208B) connected to the ground member (201), a third resonator (208C) not connected to the ground member (201), a fourth resonator (208D) connected to the ground member (201), and a fifth resonator (208E) not connected to the ground member (201) may be sequentially arranged. When the plurality of resonators is arranged in the interdigital form, a plurality of notches (n) may be easily formed. Desired frequency responses may be obtained by using the interdigital arrangement.

Frequency responses may vary depending on an angle between adjacent resonators (208) and a distance between a head portion (210) and an inner surface of the housing. For example, when an angle (A2) in the second embodiment (FIG. 6) is varied, or when a distance (d3) is varied, frequency responses may be varied.

Frequency responses may vary depending on a distance between the ground member (201) and the head portion (210). For example, when a distance (d2) between a third head portion (210C) and the ground member (201) in FIG. 6 is varied, a waveform of a frequency response graph, a position of a notch (n2), a number of notches (n2), and a magnitude of amplitude reduction may be varied.

Frequency responses may vary depending on a size of the head portion (210) and a shape of the head portion (210). Referring to FIG. 6, the third head portion (210C) has a smaller size than other head portions (210). The third head portion (210C) has a different shape compared to other head portions (210). For example, the third head portion (210C) has a shape different from that of an adjacent fourth head portion (210D). As in the third embodiment, desired frequency responses may be obtained by adjusting sizes and shapes of the head portions (210).

A third embodiment will be described below. Descriptions will focus on matters not previously described. Descriptions overlapping with those described above will be omitted or briefly described.

Referring to FIGS. 8 to 10, a filter structure (3) according to a third embodiment of the present disclosure may comprise a first resonator (308A) to a fifth resonator (308E). The first resonator (308A) to the fifth resonator (308E) may be sequentially arranged along a counterclockwise direction about the ground member (301). The first resonator (308A) may be connected to the input port (311), and the fifth resonator (308E) may be connected to the output port (313).

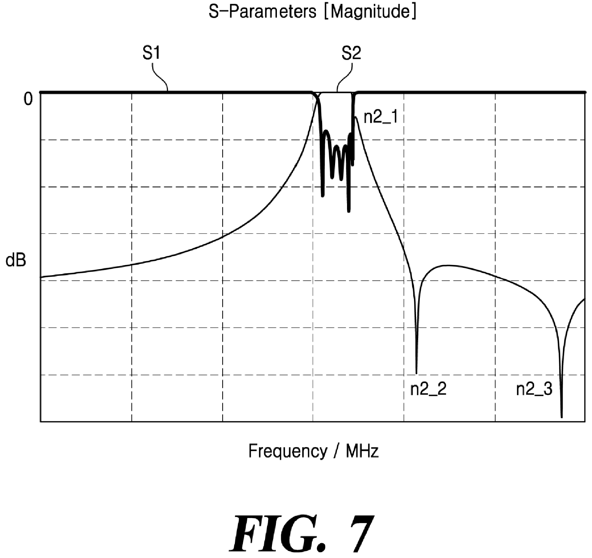

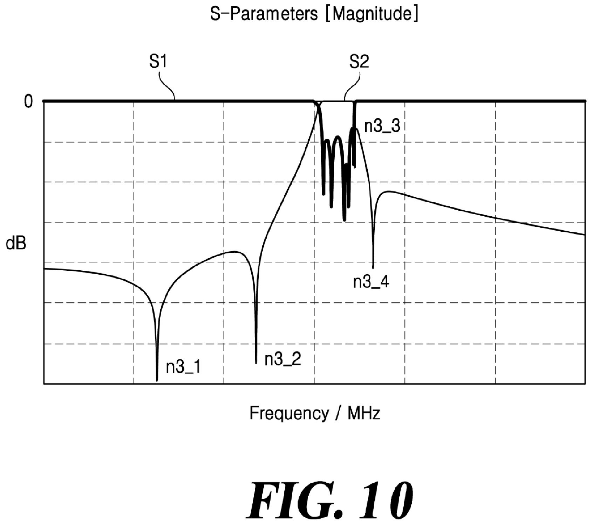

According to the third embodiment, the filter structure (3) may comprise a passage (315). The passage (315) enables an electrical connection between the plurality of resonators (308). Depending on the passage (315), a waveform of a frequency response graph, a position of a notch (n3), a number of notches (n3), and a magnitude of amplitude reduction may be varied. A greatest difference between the third embodiment (FIGS. 8 to 10) and the second embodiment (FIGS. 5 to 7) is whether the passage (315) is included. Due to presence or absence of the passage (315), the third embodiment and the second embodiment have different frequency responses (FIGS. 7 and 10). Specifically, in the third embodiment, notches (n3) are generated on left and right sides with respect to a passband, whereas in the second embodiment, a notch (n2) is generated on a right side with respect to the passband.

A fourth embodiment will be described below. Descriptions will focus on matters not previously described. Descriptions overlapping with those described above will be omitted or briefly described.

Referring to FIGS. 11 to 13, a filter structure (4) according to a fourth embodiment of the present disclosure may comprise a first resonator (408A) to a fifth resonator (408E). The first resonator (408A) to the fifth resonator (408E) may be sequentially arranged along a counterclockwise direction about the ground member (401). The first resonator (408A) may be connected to the input port (411), and the fifth resonator (408E) may be connected to the output port (413). According to the fourth embodiment, the first resonator (408A), the third resonator (408C), and the fifth resonator (408E) may be connected to the ground member (401), and the second resonator (408B) and the fourth resonator (408D) may not be connected to the ground member (401). According to the fourth embodiment, a notch (n4) may be generated on a right side with respect to a passband illustrated in a frequency response graph.

According to the fourth embodiment, an arrangement of the plurality of resonators (408) may be in an interdigital form. Specifically, a first resonator (408A) connected to the ground member (401), a second resonator (408B) not connected to the ground member (401), a third resonator (408C) connected to the ground member (401), a fourth resonator (408D) not connected to the ground member (401), and a fifth resonator (408E) connected to the ground member (401) may be sequentially arranged. When the plurality of resonators is arranged in the interdigital form, a plurality of notches (n4) may be easily formed. Desired frequency responses may be obtained by using the interdigital arrangement.

A fifth embodiment will be described below. Descriptions will focus on matters not previously described. Descriptions overlapping with those described above will be omitted or briefly described.

Referring to FIGS. 14 to 16, a filter structure (5) according to a fifth embodiment of the present disclosure may comprise a first resonator (508A) to a fifth resonator (508E). The first resonator (508A) to the fifth resonator (508E) may be sequentially arranged along a counterclockwise direction about the ground member (501). The first resonator (508A) may be connected to the input port (511), and the fifth resonator (508E) may be connected to the output port (513).

According to the fifth embodiment, the first resonator (508A), the second resonator (508B), the fourth resonator (508D), and the fifth resonator (508E) may be connected to the ground member (501). The third resonator (508C) may not be connected to the ground member (501). The wall member (507) may be disposed between the first resonator (508A) and the fifth resonator (508E).

According to the fifth embodiment, the filter structure (5) may further comprise a penetration member (550) penetrating the wall member (507). A shape of the penetration member (550) is not limited by the disclosure of the drawings. For example, the penetration member (550) may have a cylindrical shape. The penetration member (550) may have a spherical shape.

Although the wall member (507) blocks an electrical connection, when the wall member (507) comprises the penetration member (550), an electrical connection may occur. For example, the first resonator (508A) and the fifth resonator (508E) may be electrically connected by the penetration member (550).

According to the fifth embodiment, a notch (n5) may be generated on a right side with respect to a passband illustrated in a frequency response graph.

According to the fifth embodiment, only a portion of the plurality of resonators (508) may be arranged in an interdigital form. For example, in the fifth embodiment, a second resonator (508B), a third resonator (508C), and a fourth resonator (508D) are arranged in the interdigital form.

Another embodiment of the present disclosure will be described. The filter structures (1 to 5) of the present disclosure may be configured to be implemented in a microstrip line form or a strip line form by using a dielectric substrate. Here, the dielectric substrate may be a printed circuit board (PCB) substrate. In this case, the plurality of resonators (108, 208) may be configured to be disposed between dielectric substrates formed in multiple layers. As such, configurations and/or shapes of the filter structures (1 to 5) of the present disclosure are not limited by the disclosure of the drawings. The plurality of resonators (108, 208) may be disposed between various components, and even in this case, since the plurality of resonators may have an arrangement structure in which the plurality of resonators (108, 208) are not parallel to each other, cross coupling may occur between non-adjacent resonators (108, 208).

The foregoing description is merely illustrative of the technical idea of the present embodiments, and various modifications and variations may be made by those of ordinary skill in the art without departing from essential responses of the present embodiments. Accordingly, the present embodiments are intended to illustrate, but not to limit, the technical idea of the present embodiments, and the scope of the technical idea is not limited by these embodiments. The scope of protection of the present embodiments should be interpreted according to the appended claims, and all technical ideas within the equivalent scope thereof should be construed as being included in the scope of rights of the present embodiments.

### Description of Reference Numerals

101: Ground member
102: Upper surface of the ground member
103: Lower surface of the ground member
107: Wall member
108: Plurality of resonators
109: Body
110: Head portion
111: Input port
113: Output port
120: Housing
121: upper case
122: lower case
315: Passage
550: Penetration member

### CROSS-REFERENCE TO RELATED APPLICATION

This patent application claims priority to Korean Patent Application No. 10-2023-0107244, filed on August 16, 2023, which is incorporated herein by reference in its entirety.

## Claims

1. A filter structure comprising:
a housing;
a ground member disposed inside the housing and having one side in contact with the housing;
a wall member extending from an inner surface of the housing and being in contact with the ground member;
a plurality of resonators disposed inside the housing and disposed along straight lines extending in a radial direction from the ground member;
an input port connected to one of the plurality of resonators; and
an output port connected to another one of the plurality of resonators,
wherein the plurality of resonators is spaced apart from each other, and
at least one of the plurality of resonators has one side connected to the ground member.

2. The filter structure of claim 1, wherein
at least one of the plurality of resonators is electrically connected to a non-adjacent resonator.

3. The filter structure of claim 1, wherein
the ground member has another side that is not in contact with the housing.

4. The filter structure of claim 1, wherein
at least one of the plurality of resonators comprises a head portion for adjusting a frequency response.

5. The filter structure of claim 1, wherein
a resonator among the plurality of resonators that is connected to the ground member is not in contact with an inner surface of the housing.

6. The filter structure of claim 5, wherein
the resonator among the plurality of resonators that is connected to the ground member comprises a head portion at another side.

7. The filter structure of claim 1, wherein
at least one of the plurality of resonators is not connected to the ground member, and
a resonator among the plurality of resonators that is not connected to the ground member has one side in contact with an inner surface of the housing.

8. The filter structure of claim 7, wherein
a resonator among the plurality of resonators that is not connected to the ground member comprises a head portion at another side.

9. The filter structure of claim 1, wherein
a shape of each of the plurality of resonators is independently formed.

10. The filter structure of claim 1, wherein
the wall member comprises a passage for generating an electrical connection between the plurality of resonators.

11. The filter structure of claim 1, further comprising
one or more penetration members penetrating the wall member.

12. The filter structure of claim 1, wherein
a resonator connected to the input port and a resonator connected to the output port are disposed adjacent to each other.

13. The filter structure of claim 12, wherein
the wall member is disposed between the resonator connected to the input port and the resonator connected to the output port.

14. The filter structure of claim 1, wherein
a cross section of the ground member that is perpendicular to a longitudinal direction of the ground member has a polygonal shape.

15. The filter structure of claim 1, wherein
the plurality of resonators is alternately arranged between resonators connected to the ground member and resonators not connected to the ground member.

16. The filter structure of claim 1, wherein
all of the plurality of resonators are connected to the ground member.

17. The filter structure of claim 1, wherein
the plurality of resonators comprises first to fifth resonators that are sequentially arranged along a counterclockwise direction about the ground member,
the first resonator is connected to the input port,
the fifth resonator is connected to the output port,
the first resonator, the third resonator, and the fifth resonator are not connected to the ground member, and
the second resonator and the fourth resonator are connected to the ground member.

18. The filter structure of claim 17, wherein
the wall member is disposed between the first resonator and the fifth resonator, and
the wall member comprises a passage for generating an electrical connection between the plurality of resonators.

19. The filter structure of claim 1, wherein
the plurality of resonators comprises first to fifth resonators that are sequentially arranged along a counterclockwise direction about the ground member,
the first resonator is connected to the input port,
the fifth resonator is connected to the output port,
the first resonator, the third resonator, and the fifth resonator are connected to the ground member, and
the second resonator and the fourth resonator are not connected to the ground member.

20. The filter structure of claim 1, further comprising
at least one penetration member penetrating the wall member,
wherein the plurality of resonators comprises first to fifth resonators that are sequentially arranged along a counterclockwise direction about the ground member,
the first resonator is connected to the input port,
the fifth resonator is connected to the output port,
the first resonator, the second resonator, the fourth resonator, and the fifth resonator are connected to the ground member,
the third resonator is not connected to the ground member, and
the wall member is disposed between the first resonator and the fifth resonator.

21. The filter structure according to claim 1, wherein
the filter structure is configured to be implemented in a microstrip line form or a strip line form by comprising at least one dielectric substrate.
